# EUROPÄISCHE PATENTANMELDUNG

(11) **EP 0 939 435 A1**
(43) Veröffentlichungstag der Anmeldung: **01.09.1999**
(21) Anmeldenummer: 98122720.0
(22) Anmeldetag: 30.11.1998
(51) Int. Cl.: H01L 21/3215, H01L 21/28

(54) **Kontakt zwischen einem monokristallinen Siliziumgebiet und einer polykristallinen Siliziumstruktur und Herstellverfahren für einen solchen Kontakt**

(30) Priorität: 25.02.1998 US 30227
(71) Anmelder: SIEMENS AKTIENGESELLSCHAFT, 80333 München (DE)
(72) Erfinder: Schrems, Martin Dr., 01465 Langebrück (DE); Morhard, Klaus-Dieter Dr., 01099 Dresden (DE); Wurster, Kai, 01099 Dresden (DE); Hoepfner, Joachim, 82152 Planegg (DE)

(57) **Zusammenfassung**

Zur Erzeugung eines Kontaktes zwischen einer polykristallinen Siliziumstruktur (4,16) und einem monokristallinen Siliziumgebiet (2,20) ist vorgesehen, die Siliziumstruktur in amorpher oder polykristalliner Form und/oder das monokristalline Siliziumgebiet mit einem Sauerstoff enthaltenden Dotierstoff in einer derartigen Konzentration zu dotieren, daß die Löslichkeitsgrenze überschritten ist. Bei einer nachfolgenden Temperaturbehandlung bilden sich Siliziumoxidausscheidungen, die entweder das Kornwachstum in der polykristallinen Siliziumschicht (4,16) steuern, oder in dem monokristallinen Siliziumgebiet das Ausbreiten von Kristallfehlern in das Substrat hinein verhindern. Ein derartiger Kontakt ist insbesondere einsetzbar als buried strap in einer DRAM-Grabenzelle.

## Beschreibung

Die Erfindung betrifft eine Halbleiteranordnung mit einem monokristallinen Siliziumgebiet und einer daran anschließenden polykristallinen Siliziumstruktur, sowie ein Herstellverfahren für eine derartige Halbleiteranordnung.

Bei der Herstellung von integrierten Schaltungen werden häufig Kontakte zwischen einem monokristallinen Siliziumgebiet und einer polykristallinen Siliziumstruktur benötigt. Das monokristalline Gebiet wird meist vom Silizium-Halbleitersubstrat selbst gebildet, beispielsweise von einem im Siliziumsubstrat erzeugten dotierten Siliziumgebiet, wie es für MOS- oder Bipolartransistoren benötigt wird. Die polykristalline Siliziumstruktur stellt einen elektrischen Anschluß für das monokristalline Siliziumgebiet dar und wird entweder aus einer polykristallinen Siliziumschicht erzeugt oder aus einer amorphen Siliziumschicht, die in späteren Verfahrensschritten polykristallin wird.

Bei nachfolgenden thermischen Schritten tritt eine Kristallisation bzw. eine Rekristallisation der amorphen bzw. polykristallinen Siliziumstruktur ein. Dabei ist zu berücksichtigen, daß die Grenzfläche zwischen dem monokristallinen Siliziumgebiet und der Siliziumstruktur meist ein dünnes Oxid aufweist oder anderweitig verunreinigt oder qualitätiv minderwertig sein kann. Dies kann zu unkontrollierter (Re-)kristallisation führen, d.h. räumlich stark schwankenden Korngrößen. Der dabei entstehende mechanische Streß kann durch Kristalldefektbildung im monokristallinen Silizium, wie beispielsweise Versetzungsbildung, abgebaut werden. Diese Kristalldefekte verschlechtern die elektrischen Eigenschaften des Substrats, beispielsweise durch einen erhöhten Leckstrom, es besteht also die Gefahr, daß im Substrat angeordnete Bauelemente oder aktive Strukturen (z.B. Transistoren, Grabenkondensatoren, p/n-Übergänge) nicht die vorbestimmten elektrischen Eigenschaften aufweisen, sondern bereits anfängliche Fehler oder auch mittel- und langfristige Qualitätseinbußen aufweisen.

Ein erstes Beispiel für einen derartigen Kontakt ist der Bitleitungskontakt in einem DRAM-Speicher , wobei der Speicherzelltyp beliebig sein kann (beispielsweise sogenannte stacked-Zelle oder Grabenzelle).

Ein weiteres Beispiel für eine Halbleiterschaltung mit einem derartigen Kontakt ist eine DRAM-Speicherschaltung, bei der jede Speicherzelle einen Grabenkondensator und einen zugehörigen Auswahltransistor aufweist. Bei einer solchen Zelle wird in das Silizium-Substrat ein Graben geätzt, und der überwiegende Teil der Grabenwand wird mit einem Kondensator-Dielektrikum bedeckt. In dem Artikel von E.Adler et al. 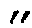 The Evolution of IBM CMOS DRAM Technology", IBM J. of Research and Development, 1995, Vol.39, N0 ½, IBM CMOS Technology, sind DRAM-Speicher näher beschrieben. Es ist üblich, aber nicht unbedingt erforderlich, den oberen Teil der Grabenwand mit einem dickeren Isolationskragen (sog. collar) zu versehen. Der Graben wird mit dotiertem polykristallinen Silizium aufgefüllt, daß die Speicherelektrode bildet, die zweite Kondensatorelektrode wird als 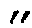 buried plate" in geeigneter Weise vom Substrat gebildet. Der Graben ist benachbart zum zugehörigen Auswahltransistor angeordnet, wobei der Kontakt zwischen der Speicherelektrode und einem dotierten Gebiet des Transistors entweder über eine Polysiliziumstruktur an der Oberfläche des Substrats (sog. surface strap) erfolgt, oder, wenn zur Verringerung des Platzbedarfs der Graben direkt benachbart zu einem dotierten Gebiet des Auswahltransistors angeordnet ist, an der dazwischenliegenden Stelle der Grabenwand, wobei diese Stelle keine Isolation aufweisen darf. Der Kontakt zum dotierten Gebiet des Transistors stellt also einen Kontakt zwischen monokristallinem und polykristallinem Silizium dar und kann entweder an der Oberfläche des Substrats liegen oder ein Grabenwandkontakt sein. Während späterer thermischer Schritte (beispielsweis Ausheilprozesse, Schichtabscheidungen) können hier die oben erläuterten Probleme auftreten und zum Ausfall von Speicherzellen oder zu Zellen mit verringerter Retention time führen. Besondere Schwierigkeiten bereiten dabei Zellen mit variabler Retention time (sog. VRT-Zellen), bei denen sich die Retention time sprunghaft mit der Zeit ändert. Derartige Zellen können daher durch elektrische Tests nur teilweise detektiert werden, was zu einem späteren Ausfall im Kundenbetrieb führt.

Ein Beispiel für ein Herstellverfahren für derartige Speicherzellen ist in US-PS 5,360,758 beschrieben. Dabei wird der Grabenwandkontakt mittels einer in den oberen Bereich eingebrachten Polysiliziumschicht ( 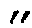 buried strap") erzeugt. An der Grenzfläche zwischen dem monokristallinen Silizium und dem buried strap befindet sich vor Abscheidung des buried strap eine dünne Siliziumoxidschicht, die durch eine naßchemische Reinigung oder eine thermische Oxidation vor dem Abscheiden des amorphen oder polykristallinen Siliziums für den buried strap entsteht. Diese Oxidschicht bricht im allgemeinen während nachfolgender thermischer Schritte auf. Dabei ist die Dicke der Oxidschicht, die durch ihren Herstellprozeß und die anschließende Verweildauer an Luft bestimmt ist, wesentlich. Ist die Oxidschicht dünn, insbesondere < 1 nm, so bricht sie während nachfolgender thermischer Schritte unter Ausbildung von Oxidbällchen (SiOₓ) mit x ≈ 2) an der Grenzfläche auf. Dadurch wird der Übergangswiderstand an der Grenzfläche soweit abgesenkt, daß der Kondensator, d.h. die Speicherelektrode im Graben, ausreichend schnell beladen werden kann. Die Bildung der Oxidbällchen, d.h. ihre Größe und ihr mittlerer Abstand, ist dabei praktisch nicht kontrollierbar. Zwischen den Oxidbällchen kommt es zu unkontrollierter (Re-)kristallisation des buried strap Siliziums. Wie erläutert, führt der dabei entstehende mechanische Streß zu Kristalldefektbildung, insbesondere Versetzungen, im monokristallinen Silizium. Daher sollte die Oxidschicht erst nach den Hochtemperaturschritten des gesamten Herstellverfahrens aufbrechen, um Versetzungen zu vermeiden.

Wird eine zu dicke Oxidschicht gewählt, bricht diese gar nicht auf. Dann wird zwar die Bildung von Versetzungen und anderen Kristallfehlern vermieden, aber der elektrische Widerstand zu dem dotierten Gebiet des Auswahltransistors und dem Kondensator ist so hoch, daS die Speicherelektrode während der Schreib-/Lesezyklen nicht oder nicht mehr ausreichend be- oder entladen werden kann.

Es ist bisher unter Fertigungsbedingungen nicht gelungen, eine Oxidschicht herzustellen, die an jeder Stelle eines Silizium-Wafers genau zum richtigen Zeitpunkt aufbricht.

Aufgabe der Erfindung ist es daher, einen Kontakt zwischen einem monokristallinen Siliziumgebiet und einer polykristallinen Siliziumstruktur mit geringem Übergangswiderstand anzugeben, bei dem das Auftreten bzw. die Ausbreitung von Versetzungen im monokristallinen Silizium vermieden wird, sowie ein Herstellverfahren für einen solchen Kontakt anzugeben. Insbesondere soll der Kontakt als Bitleitungskontakt in einer Speicherzelle einsetzbar sein, er soll ferner als Oberflächen- oder Grabenwandkontakt zwischen einer Grabenauffüllung und einem dotierten Gebiet im monokristallinen Siliziumsubstrat bei einer DRAM-Speicherzelle einsetzbar sein. Diese Aufgabe wird durch einen Kontakt mit den Merkmalen des Anspruchs 1 und ein Herstellverfahren mit den Merkmalen des Anspruchs 10 gelöst.

Die Erfindung setzt eine Dotierung der nicht monokristallinen Siliziumstruktur und/oder des monokristallinen Siliziumgebietes mit einem Dotierstoff aus der Gruppe:
Sauerstoff, Sauerstoff/Stickstoff-Gemische, Sauerstoff/Stickstoff-Verbindungen, andere sauerstoffhaltige Gemische oder Verbindungen ein, wobei die Konzentration des Dotierstoffs so gewählt wird, daß die Löslichkeitsgrenze des Dotierstoffs überschritten ist (die genannten Dotierstoffe können auch kurz als sauerstoffhaltige Dotierstoffe bezeichnet werden). Dadurch bilden sich bei nachfolgenden thermischen Schritten Dotierstoffausscheidungen in dem monokristallinen Gebiet oder in der nicht-monokristallinen Siliziumstruktur. Bei Dotierung der Siliziumstruktur lassen diese das Kornwachstum in der Siliziumstruktur nur bis zu einer bestimmten Größe zu. Diese Korngröße wird durch die Dichte (d.h. den mittleren Abstand) der Dotierstoffausscheidungen bestimmt. Die Dotierstoffausscheidungen haben also quasi eine Käfigwirkung. Je höher die Dichte der Dotierstoffausscheidungen ist, desto geringer ist die maximale und die mittlere Polysilizium-Korngröße in der Siliziumstruktur. Die mittlere Anzahl (d.h. die Dichte) der Dotierstoffausscheidungen wird durch die Dotierstoffübersättigung (Dotierstoffkonzentration dividiert durch die Löslichkeitskonzentration) und das thermische Budget (ramp-Raten, Haltetemperaturen) bei den nachfolgenden thermischen Behandlungen kontrolliert. Bei Dotierung des monokristallinen Siliziumgebietes entstehen hier Dotierstoffausscheidungen, die als Barriere gegen die Ausbreitung von Versetzungen wirken.

Die erfindungsgemäße Halbleiteranordnung mit einem monokristallinen Siliziumgebiet und einer polykristallinen Siliziumstruktur ist gekennzeichnet durch Dotierstoffausscheidungen in der polykristallinen Siliziumstruktur oder im monokristallinen Silizium, wobei im ersten Fall die mittlere und die maximale Korngröße des Polysiliziums durch die Dichte der Dotierstoffausscheidungen bestimmt ist. Dabei können das monokristalline Siliziumgebiet und das Polysilizium übereinander angeordnet sein, so daß ein horizontaler Kontakt entsteht, oder in beliebiger anderer Orientierung, z. B. nebeneinander (vertikaler Kontakt).

Mit der Erfindung wird die unkontrollierte (Re-)kristallisation in der Siliziumstruktur und die Kristalldefektbildung im Monosilizium vermieden bzw. die Ausbreitung von Kristalldefekten im Monosilizium begrenzt. Gleichzeitig wird ein niedriger Übergangswiderstand zwischen der polykristallinen Siliziumstruktur und dem monokristallinen Siliziumgebiet erzielt.

Als Dotierstoff ist insbesondere Sauerstoff geeignet, da aufgrund der niedrigen Löslichkeit des Sauerstoffs Ausscheidungen besonderns leicht gebildet werden. Es ist also keine hohe Dotierung notwendig. Die Leitfähigkeit der Silizium-Struktur oder des Silizium-Gebietes wird nicht entscheidend vermindert. Sauerstoffausscheidungen liegen dann als SiOₓ mit x ≈ 2 vor.

Als Dotierverfahren können insbesondere Ionen-Implantation, Plasma-Doping oder Plasma Immersion Ion Implantation (PIII) eingesetzt werden. Diese Verfahren sind dem Fachmann geläufig und beispielsweise in den US-Patentschriften 4,937,205 und 5,354,381 sowie in Jap. J. Appl. Phys. Vol 35 (1996), p.1027-1036 näher erläutert. Beim Plasma-Doping kann die Dosis besonders gut kontrolliert werden. Die Dotierung kann so erfolgen, daß der Dotierstoff in der Siliziumstruktur gleichmäßig verteilt wird, d.h. eine im wesentlichen überall gleiche Dotierstoff-Konzentration vorliegt, die über der Löslichkeitsgrenze liegt. Andererseits kann ein Dotierstoff-Maximum in einem vorbestimmten Teil des Siliziumgebietes oder der Siliziumstruktur erzeugt werden, beispielsweise in der Nähe des Kontaktes oder in einer vorgegebenen Tiefe. Ferner kann auch eine Dotierung eines kontaktnahe Gebietes des Monosiliziums anstelle oder zusätzlich zur Siliziumstruktur erfolgen. Es entstehen dann Dotierstoffausscheidungen im monokristallinen Silizium in der Nähe des Kontaktes, die als Barriere gegen Ausbreitung von Versetzungen aus dem polykristallinen Silizium wirken.

Die Siliziumstruktur kann auch in situ durch Zudosierung von bspw. O₂, NO, N₂O, H₂O während der Abscheidung von polykristallinem oder amorphem Silizium dotiert werden. Dazu kann ein Verfahren entsprechend der bekannten In-Situ-Dotierung eingesetzt werden. Ein weiteres geeignetes Dotierverfahren ist in US-PS 5 354 710 beschrieben.

Die Konzentration des Dotierstoffs im Silizium liegt im Bereich 10¹⁷ bis 10²¹ cm⁻³, vorzugsweise im Bereich 10¹⁸ bis 10²⁰ cm⁻³

Weitere Einzelheiten zur Herstellung der polykristallinen Siliziumstruktur sind in der deutschen Patentanmeldung 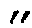 Herstellverfahren für eine polykristalline Siliziumstruktur" desselben Anmelders und derselben Erfinder mit demselben Anmeldetag beschrieben, sowie in der US-Patentanmeldung Appl. No 09/030 406, Anmeldetag 25.2.98, deren Gesamtoffenbarungen hier miteinbezogen werden.

Die Erfindung wird im folgenden anhand von Ausführungsbeispielen, die in den Figuren dargestellt sind, näher beschrieben. Es zeigen
FIG 1, 2: Einen Querschnitt durch ein Halbleitersubstrat mit einem monokristallinen Siliziumgebiet, an dem ein erstes Ausführungsbeispiel der Erfindung verdeutlicht wird,
FIG 3 bis 11: Querschnitte durch ein Halbleitersubstrat während der Herstellung eines DRAMs zur Erläuterung der Ausführungsbeispiele 2 bis 5 des erfindungsgemäßen Verfahrens, wobei FIG 3 als Ausgangspunkt für die Ausführungsbeispiele 2 bis 5 dient.

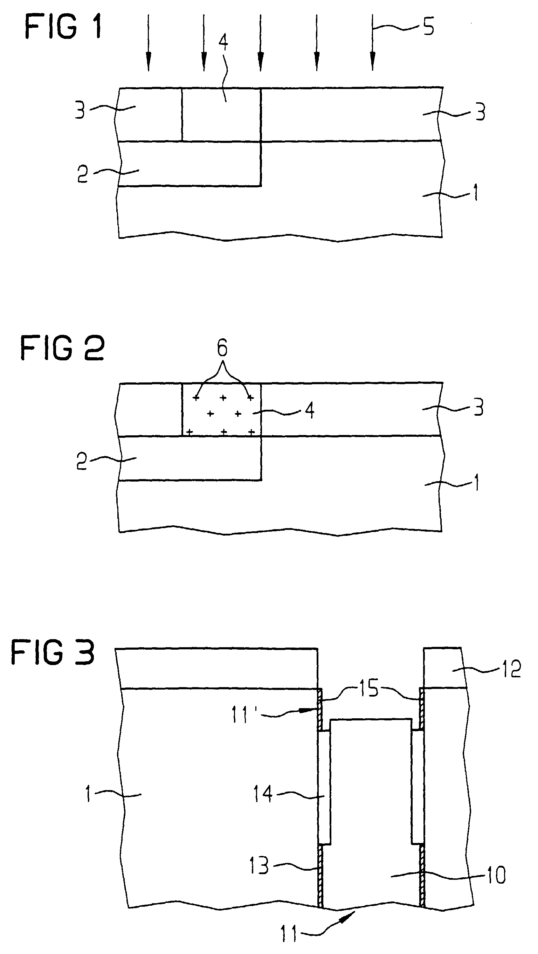

FIG 1: Ein Siliziumsubstrat 1 weist an seiner Oberfläche ein dotiertes monokristallines Gebiet 2 auf, das beispielsweise ein Sourcegebiet eines MOS-Transistors sein kann. Auf dem dotierten monokristallinen Gebiet 2 ist eine Siliziumstruktur 4 angeordnet, die nicht monokristallin ist, sondern beispielsweise polykristallin, und durch einen Abscheideprozeß erzeugt wurde. Übrige Bereiche der Anordnung sind mit einer Isolation 3 versehen. Erfindungsgemäß wird diese Polysiliziumstruktur 4 mit einem sauerstoffhaltigen Dotierstoff 5, beispielsweise Sauerstoff dotiert. Die Dotierung kann beispielsweise durch eine vertikale Ionenimplantation erfolgen. Die Implantation kann ganzflächig ausgeführt werden, wenn dies mit der übrigen Halbleiterschaltung kompatibel ist. Dabei werden die Implantationsparameter so gewählt, daß die erreichte Dotierstoffkonzentration in der Polysiliziumstruktur 4 die Löslichkeitsgrenze überschreitet. Beispielsweise wird bei einer 100 - 200 nm dicken Polysiliziumschicht 4 eine Dosis von etwa 5 x 10¹³ cm⁻² bei einer Energie von 3 - 5 keV gewählt.

FIG 2: Anschließend wird ein Temperaturschritt durchgeführt, beispielsweise 30 min bei 900 - 1000° C, wodurch Dotierstoffausscheidungen 6, hier Si0ₓ-Ausscheidungen (x ≈ 2), in der Polysiliziumstruktur 4 gebildet werden. Diese begrenzen, wie oben erläutert, das Kornwachstum im Polysilizium und verhindern dadurch die Ausbreitung von Kristallfehlern in das dotierte Gebiet 2 und in das Substrat 1 (FIG 2).

FIG 3: Ausgangspunkt für die weiteren Ausführungsbeispiele ist ein Halbleitersubstrat mit einer teilweise fertiggestellten DRAM-Speicherzelle. Dabei werden nur die für die Erfindung wesentlichen Strukturen und Verfahrensschritte erläutert. Das Siliziumsubstrat 1 weist einen Graben 11 zur Aufnahme einer Speicherelektrode 10 auf. Der Graben ist mit bekannten Verfahren unter Verwendung einer Graben-Ätzmaske 12 erzeugt worden. Der untere Bereich der Grabenwand (einschließlich des Gabenbodens) ist mit einem Kondensatordielektrikum 13 versehen, der obere Bereich ist mit einem dickeren Oxidkragen 14 ausgekleidet. Der Graben ist mit dotiertem Polysilizium 10 aufgefüllt, wobei das Polysilizium hier zur Erzeugung eines buried strap bis unter die Substratoberfläche zurückgeätzt ist. Der Oxidkragen ist mindestens an einer Stelle 11' der oberen Grabenwand, und zwar an der Oberkante des Grabens entfernt, um den Anschluß an ein im Substrat zu bildendes dotiertes Gebiet des Auswahltransistors zu ermöglichen. Im vorliegenden Beispiel ist die gesamte Grabenoberkante freigelegt. Es wird eine Vorreinigung, beispielsweise BHF, durchgeführt, die zu einer Oxidschicht 15 an der freigelegten Grabenwand 11' führt. Hier wird etwa 0,3 bis 0,7 nm Siliziumoxid gebildet. Weitere Einzelheiten für ein geeignetes Herstellverfahren sind in der US-Patentschrift 5,360,758, insbesondere Spalte 1, Zeile 58 bis Spalte 4, Zeile 49 beschrieben. Diese Struktur (ggf. mit weiteren Verfahrensschritten, die für die Erfindung nicht wesentlich sind) dient als Ausgang für die weiteren Beispiele zur Kontaktherstellung.

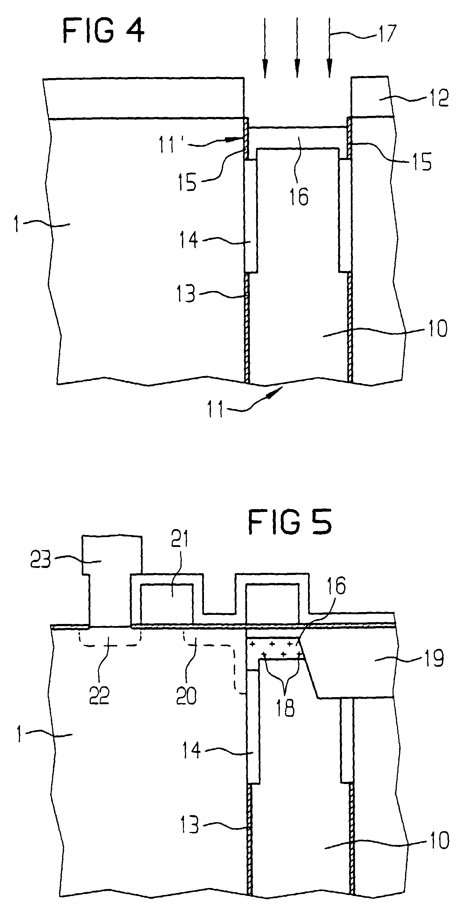

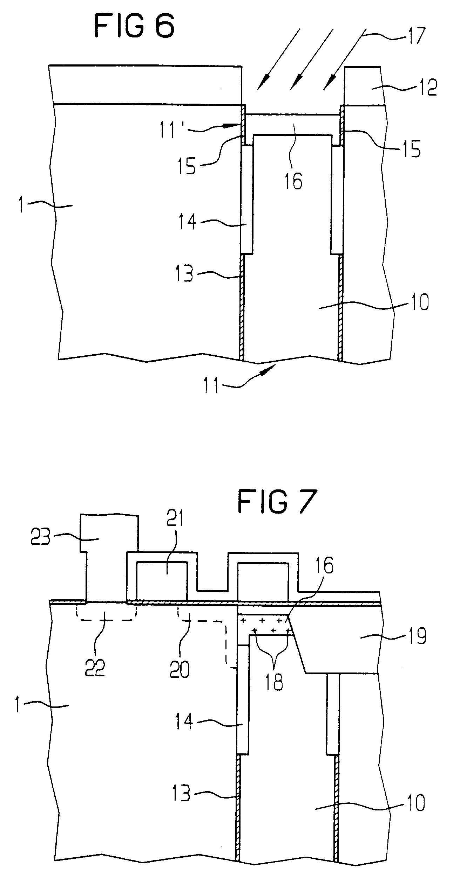

FIG 4, 5: Eine Siliziumstruktur 16 wird durch Abscheidung einer 300 nm dicken undotierten amorphen Siliziumschicht bei ca. 550° C mit anschließender Rückätzung hergestellt, so daß der so erzeugte buried strap 16 völlig innerhalb des Grabens liegt. Vorzugsweise liegt seine Oberkante unterhalb der Substratoberfläche, beispielsweise um etwa 50 nm. Die Rückätzung kann mit einem chemischen Trockenätzverfahren oder reaktivem Ionenätzen erfolgen. Anstelle von amorphen Silizium kann auch polykristallines Silizium abgeschieden werden, wobei die Prozeßtemperatur typischerweise 600 bis 650 °C beträgt. Die Dotierung mit Sauerstoff erfolgt mittels vertikaler Ionenimplantation 17 (Dosis etwa 5 x 10¹³ cm⁻², Energie 3 bis 5 keV) oder Sauerstoff-Plasmadoping (Zeit: 10 sec, Energie 1 keV). Es wird eine gleichmäßige Verteilung der Sauerstoffausscheidungen 18 im buried strap erreicht. Die weitere Fertigstellung der Speicherzelle erfolgt nach bekannten Verfahren (siehe beispielsweise die angegebene US-Patentschrift). Insbesondere werden zur Isolation benachbarter Speicherzellen gegeneinander sogenannte shallow-trench-Isolationsgebiete 19 hergestellt, indem eine Vertiefung geätzt wird, die einen Teil der Grabenwand überlappt. Sie wird mindestens bis zum Oxidkragen 14 geätzt und dann mit einer Isolation 19 aufgefüllt. Dadurch ist in diesem Gebiet kein Kontakt zwischen dem buried strap 16 und dem Substrat mehr vorhanden. Der Auswahltransistor 24, 20, 21, 22 ( Gateoxid, Source, Gate, Drain) wird hergestellt, wobei ein dotiertes Gebiet 20 an die dem Isolationsgebiet 19 gegenüberliegende Grabenwand 11' anschließt, so daß hier der Kontakt zur Speicherelektrode erfolgt. Das andere dotiertde Gebiet 22 wird durch die Bitleitung 23 kontaktiert.

FIG 6, 7: Das dritte Ausführungsbeispiel unterscheidet sich vom zweiten durch eine schräge Implantation des Dotierstoffs, die übrigen Verfahrensschritte können gleich durchgeführt werden. Der Implantationswinkel beträgt je nach räumlicher Anordnung der Strukturen 20° bis 40°, insbesondere etwa 30°, die Dosis 3 bis 5 x 10¹³ cm⁻², die Energie etwa 15 bis 20 keV. Das Maximum der Dotierstoffverteilung wird dadurch in der Nähe der Grenzfläche zwischen Monosilizium und buried strap erzielt, daher ist hier die Dichte der Dotierstoffausscheidungen 18 größer, und das Kornwachstum kann an dieser Stelle besonders gut kontrolliert werden.

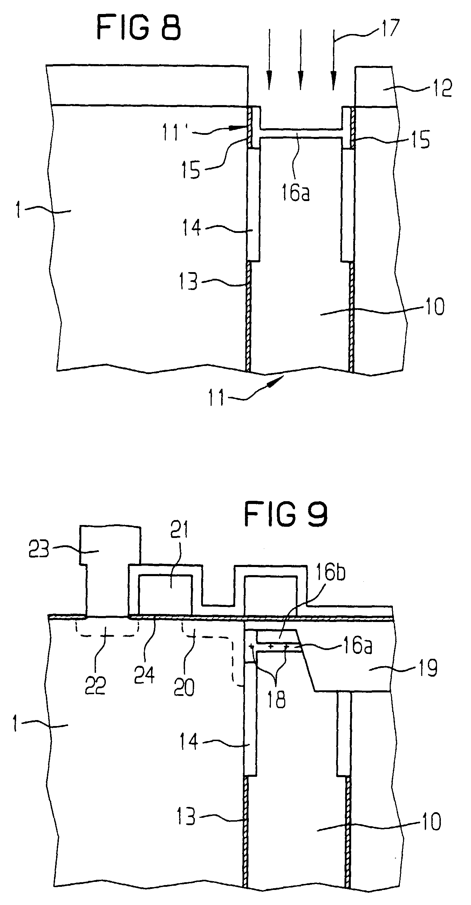

FIG 8, 9: Im vierten Beispiel wird nach der Vorreinigung zunächst eine dünne, beispielsweise ca. 10 nm dicke undotierte amorphe Siliziumschicht 16a bei etwa 500 bis 550°C abgeschieden. Diese wird mittels Plasmadoping oder vertikaler Ionenimplantation dotiert, wobei die Parameter wie in Beispiel 2 gewählt werden können. Dann wird amorphes oder polykristallines Silizium 16b in der notwendigen Restdicke, hier also 290 nm, abgeschieden und wie zuvor rückgeätzt, so daß der buried strap 16a, b gebildet wird. Die Speicherzelle wird wie vorher beschrieben, fertiggestellt. Mit diesem Beispiel wird das Konzentrationsmaximum in die Tiefe gesetzt und eine gleichmäßige Verteilung von Dotierstoffausscheidungen 18 in einer dünnen Siliziumschicht 16a erzielt.

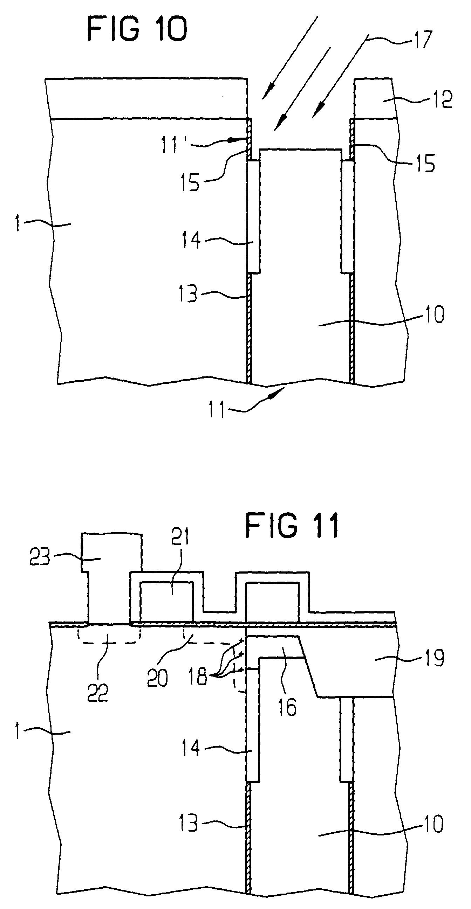

FIG 10, 11: Im fünften Beispiel werden die Dotierstoffausscheidungen 18 nicht in der Siliziumstruktur (buried strap), sondern im monokristallinen Silizium als Barriere gegen die Ausbreitung von Versetzungen erzeugt. Dazu wird nach der Vorreinigung, durch die eine dünne Oxidschicht 15 an der Grabenwand 11' erzeugt wird, die Dotierung durchgeführt. Es kann ein Plasma-Doping oder eine vertikale Implantation mit den oben angegebenen Paramentern durchgeführt werden. Bevorzugt wird aber eine schräge Implantation, (beispielsweise 30°, 5 keV, 3 bis 5 x 10¹³ cm⁻²) eingesetzt, da dann gezielt in das monokristalline Silizium an der freien oberen Grabenwand 11' implantiert wird. Nach der Dotierung erfolgt die Abscheidung von amorphem oder polykristallinem Silizium von etwa 300 nm Dicke und Rückätzung zum buried strap 16 sowie das weitere Verfahren wie in den vorherigen Beispielen.

Die Ausführungsbeispiele 2 bis 5 sind anhand der in US 5 360 758 dargestellten Speicherzelle beschrieben, bei der die Isolation benachbarter Gräben durch eine STI-Wanne nach Erzeugung des buried strap erfolgt. Die Erfindung kann aber auch in anderen Speicherzellen und Herstellverfahren eingesetzt werden. Beispielsweise kann ein Grabenkondensator über einen surface strap mit dem Transistor verbunden werden, oder ein sogenannter stacked capacitor kann an den Auswahltransistor angeschlossen werden.

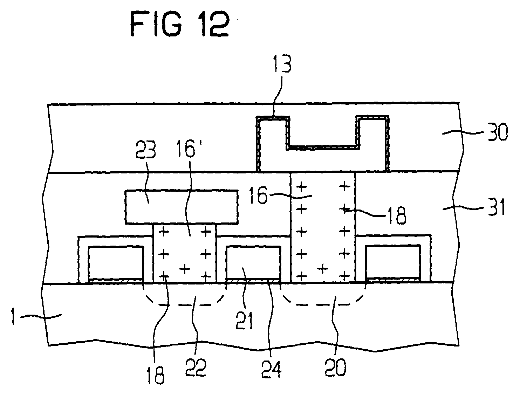

FIG 12 zeigt eine DRAM-Zelle mit einem oberhalb von Transistor und Bitleitung 23 angeordneten stacked capacitor. Dabei sind sowohl die Bitleitung 23 als auch der Kondensator 10, 13, 30 über eine erfindungsgemäß hergestellte Polysiliziumstruktur 16' bzw. 16 angeschlossen. Es wurden für die elektrisch sich entsprechenden Strukture dieselben Bezugszeichen wie in den vorherigen Beispielen verwendet, lediglich die zweite Kondensatorelektrode ist mit 30 und eine Isolationsschicht ist mit 31 bezeichnet. Die Polysiliziumstruktur 16' , 16 weisen Dotierstoffausscheidungen 18 auf, deren Dichte in der Nähe der dotierten gebiete 20,22 und der umgebenden Isolation 31 maximal ist. Dies wird durch eine anfängliche Zugabe des sauerstoffhaltigen Dotierstoffs bei der CVD-Abscheidung erreicht.

Das vierte Ausführungsbeispiel ist auch besonders gut geeignet, einen horizontalen Kontakt zu einem dotierten Gebiet im Siliziumsubstrat, beispielsweise einem Bitleitungskontakt, herzustellen. Es wird also zunächst eine dünne Polysiliziumschicht abgeschieden, diese dotiert, und dann die restliche Schichtdicke abgeschieden. Auf diese Weise werden Dotierstoffausscheidungen gezielt in der Nähe der horizontalen Grenzfläche erzeugt und das Kornwachstum an dieser Stelle gut kontrolliert.

## Patentansprüche

1. Halbleiteranordnung mit einem monokristallinen Siliziumgebiet (2, 20) und einer direkt anschließenden polykristallinen Siliziumstruktur (4, 16),
bei der das monokristalline Siliziumgebiet (2, 20) und die polykristalline Siliziumstruktur (4, 16) elektrisch leitfähig sind, und
bei der das monokristalline Siliziumgebiet (2, 20) und/oder die polykristalline Siliziumstruktur (4, 16) Dotierstoffausscheidungen (6, 18) eines sauerstoffhaltigen Dotierstoffs aufweisen.

2. Halbleiteranordnung nach Anspruch 1, bei der das monokristalline Siliziumgebiet (2, 20) ein Source- oder Drain-Gebiet eines MOS-Transistors darstellt.

3. Halbleiteranordnung nach einem der Ansprüche 1 bis 2, bei der die polykristalline Siliziumstruktur (4, 16) eine Kondensatorelektrode oder einen Anschluß einer Kondensatorelektrode darstellt.

4. Halbleiteranordnung nach einem der Ansprüche 1 bis 3, bei der das monokristalline Siliziumgebiet (2, 20) an der Oberfläche eines Halbleitersubstrats (1) gebildet ist und die polykristalline Siliziumstruktur (4, 16) an das monokristalline Siliziumgebiet horizontal oder vertikal angrenzt.

5. Halbleiteranordnung nach einem der Ansprüche 1 bis 4, bei der das polykristalline Siliziumgebiet (4, 16) die Dotierstoffausscheidungen (6, 18) aufweist, und die Korngröße der polykristallinen Siliziumstruktur durch die Dichte der Dotierstoffausscheidungen bestimmt ist.

6. Halbleiteranordnung nach Anspruch 5, bei der die Dichte der Dotierstoffausscheidungen in der gesamten polykristallinen Silziumstruktur annähernd konstant ist.

7. Halbleiteranordnung nach Anspruch 5, bei der die Dichte der Dotierstoffausscheidungen ein Maximum in der Nähe des monokristallinen Siliziumgebietes (2, 20) aufweist.

8. Halbleiteranordnung nach Anspruch 5, bei der die Dichte der Dotierstoffausscheidungen ein Maximum in einer vorgegebenen Tiefe aufweist.

9. Halbleiteranordnung nach einem der Ansprüche 1 bis 4, bei der das monokristalline Siliziumgebiet die Dotierstoffausscheidungen aufweist und die Dichte der Dotierstoffausscheidungen ein Maximum in der Nähe der polykristallinen Siliziumstruktur besitzt.

10. Verfahren zur Erzeugung eines Kontaktes zwischen einer polykristallinen Siliziumstruktur (4, 16) und einem monokristallinen Siliziumgebiet (2, 20) mit folgenden Schritten:
- Erzeugen der Siliziumstruktur (4, 16) in amorpher oder polykristalliner Form angrenzend an das monokristalline Siliziumgebiet (2, 20),
- Dotieren der Siliziumstruktur (4, 16) und/oder des monokristallinen Siliziumgebietes (2, 20) mit einem sauerstoffhaltigen Dotierstoff in einer derartigen Konzentration, daß die Löslichkeitsgrenze des Dotierstoffs in der Siliziumstruktur oder dem Siliziumgebiet überschritten ist,
- Durchführen einer Temperaturbehandlung, so daß in der Siliziumstruktur (4, 16) oder dem Siliziumgebiet (2, 20) Dotierstoffausscheidungen (6, 18) gebildet werden und die Siliziumstruktur (4, 16) kristallisiert wird.

11. Verfahren nach Anspruch 10, bei dem die Konzentration des Dotierstoffs im Bereich 10¹⁷ bis 10²¹ liegt.

12. Verfahren nach einem der Ansprüche 10 bis 11, bei dem vor Erzeugung der Siliziumstruktur (4, 16) eine dünne Oxidschicht (15) auf dem monokristallinen Siliziumgebiet (2, 20) erzeugt wird.

13. Verfahren nach einem der Ansprüche 10 bis 12, bei dem das monokristalline Siliziumgebiet zwecks Erzeugung einer n- oder p-Leitfähigkeit mit einem Dotierstoff des n- oder p-Leitfähigkeitstyps dotiert wird.

14. Verfahren nach einem der Ansprüche 10 bis 13, bei dem die Siliziumstruktur (4, 16) dotiert wird und die Korngröße der erzeugten polykristallinen Siliziumstruktur durch die Dichte der Dotierstoffausscheidungen eingestellt wird.

15. Verfahren nach Anspruch 14, bei dem die gesamte Siliziumstruktur (4, 16) gleichmäßig dotiert wird.

16. Verfahren nach Anspruch 14, bei dem das Maximum der Dotierstoffverteilung in der Siliziumstruktur in der Nähe des monokristallinen Siliziumgebietes (2, 20) gebildet wird.

17. Verfahren nach Anspruch 14, bei dem das Maximum der Dotierstoffverteilung in einer vorgegebenen Tiefe der Siliziumstruktur (4, 16) gebildet wird.

18. Verfahren nach einem der Ansprüche 10 bis 17,
bei dem in ein Halbleitersubstrat (1) ein Graben geätzt wird, der in seinem unteren Teil mit einem dünnen Dielektrikum (13) und in seinem oberen Teil mit einem dickeren Dielektrikum (14) ausgekleidet ist, und der mit einer Elektrode (10) gefüllt ist,
bei dem die Elektrode (10) etwa bis zur Tiefe des erzeugenden Kontaktes zurückgeätzt wird,
bei dem das freiliegende dicke Dielektrikum (14) bis zur Tiefe des zu erzeugenden Kontaktes entfernt wird, so daß monokristallines Silizium an der Grabenwand freiliegt,
bei dem der Graben (11) mit der Siliziumstruktur (16) aufgefüllt wird,
bei dem die Siliziumstruktur (16) und/oder die freiliegende Grabenwand (11') mit einem sauerstoffhaltigen Dotierstoff dotiert werden, wobei die Konzentration des Dotierstoffs in dem Siliziumgebiet oder der Siliziumstruktur über der Löslichkeitsgrenze liegt,
bei dem eine Vertiefung geätzt wird, die einen Teil der Grabenwand überdeckt und bis in das dicke Dielektrikum (14) reicht, und mit einer Isolation (19) aufgefüllt wird.
